Europäisches Patentamt

European Patent Office

Office européen des brevets

(11) Veröffentlichungsnummer: **0 495 380 A2**

# EUROPÄISCHE PATENTANMELDUNG

(21) Anmeldenummer: **92100205.1**

(51) Int. Cl.5: **G01R 1/067**

(22) Anmeldetag: **08.01.92**

(30) Priorität: **15.01.91 DE 9100432 U**

(43) Veröffentlichungstag der Anmeldung:
**22.07.92 Patentblatt 92/30**

(84) Benannte Vertragsstaaten:
**AT BE CH DE ES FR GB GR IT LI NL SE**

(71) Anmelder: **SIEMENS AKTIENGESELLSCHAFT**
**Wittelsbacherplatz 2**
**W-8000 München 2(DE)**

(72) Erfinder: **Rittler, Horst**
**Steinacker 4**
**W-7526 Ubstadt-Weiher 4(DE)**
Erfinder: **Schön, Adolf, Dipl.-Ing.**
**Dietrichweide 5**
**W-8134 Söcking(DE)**
Erfinder: **Rossnagel, Dieter**
**Am Nottenbach 10**
**W-7520 Bruchsal-HD(DE)**
Erfinder: **Kaiser, Mathias**
**Waldstrasse 2**
**W-7527 Kraichtal-BA(DE)**
Erfinder: **Gartner, Peter**
**Leopoldstrasse 56**
**W-7517 Waldbronn(DE)**
Erfinder: **Lehmann, Bernhard**
**Falkenweg 2**
**W-7521 Dettenheim-RU(DE)**

(54) **Tastnadel für einen elektrischen Prüfadapter.**

(57) Die Tastspitze einer Tastnadel (2) eines Federkontaktstiftes (1) besteht vollständig aus Hartmetall mit einer kugelartigen Rundung (4). Die Spitze weist eine sehr hohe Verschleißfestigkeit bei gleichbleibend guter Kontaktqualität auf.

FIG 2

Rank Xerox (UK) Business Services

Die Erfindung bezieht sich auf eine Tastnadel für einen Adapter zum Prüfen von elektrischen Leiterplatten mit einer verschleißarmen Oberfläche zumindest im Bereich einer Tastspitze.

Es ist bekannt, derartige Tastnadeln in Federkontaktstifte einzusetzen, die in Prüfadaptern für Leiterplatten mit den entsprechenden Prüfpunkten der Leiterplatte kontaktiert werden. Die Tastspitzen bestehen aus gehärtetem Stahl mit einer mehrschichtigen Oberfläche und einer äußeren Schicht aus Edelmetall. Der Tastkopf der Nadel kann unterschiedliche Formen z. B. die einer Spitze oder Krone aufweisen. Der mehrschichtige Aufbau hat jedoch den Nachteil, daß sich die Übergangswiderstände von Schicht zu Schicht summieren. Außerdem nutzen sich die dünnen Schichten relativ schnell ab, so daß die Lebensdauer der Federkontaktstifte entsprechend niedrig ist.

Bei der Prüfung von hochintegrierten elektronischen Bauelementen ist es ferner bekannt, Tastnadeln aus Hartmetall zu verwenden, deren Spitze sehr schlank und scharf ausgebildet ist. Die damit verbundene Bruchgefahr wird dadurch verringert, daß die Kontaktkräfte sehr niedrig sind und daß die zu prüfenden Oberflächen von gleichbleibend ebener Beschaffenheit sind. Wegen der sehr geringen Prüfströme ist die Kontaktqualität von untergeordneter Bedeutung.

Der Erfindung liegt die Aufgabe zugrunde, die Verschleißfestigkeit der Tastnadel zu erhöhen. Diese Aufgabe wird durch die Erfindung gemäß Anspruch 1 gelöst. Das z. B. einen hohen Wolframkarbidanteil aufweisende Hartmetall hat eine mehrfach höhere Härte als gehärteter Stahl. Da es direkt mit dem Prüfpunkt kontaktiert wird, entfallen die Übergangswiderstände an den Oberflächenschichten. Bei Leiterplatten müssen die Kontaktkräfte relativ hoch sein, um z. B. Flußmittelrückstände an den Prüfpunkten durchdringen zu können. Außerdem können die Prüfpunkte z.B. bei bestückten und gelöteten Leiterplatten so uneben sein, daß Seitenkräfte auftreten, die die relativ spröde Spitze abbrechen können. Durch die Abrundung der Spitze mit einem Radius von ca. 50 Mikrometer wird diese Gefahr erheblich verringert. Gleichzeitig ist jedoch die Spitze noch so scharf, daß eine hinreichende Durchdringung der Flußmittel und Oxidschichten der zu prüfenden Stelle gesichert ist. Es hat sich herausgestellt, daß die Leitfähigkeit des Hartmetalls hinreichend gut ist, um die Prüfströme verlustarm übertragen zu können, wobei auch nach häufiger Benutzung keine Korrosion auftritt.

Durch eine Weiterbildung der Erfindung nach Anspruch 2 wird erreicht, daß die empfindliche Tastspitze beim Auftreten von Querkräften insbesondere in Vakuumadaptern seitlich ausweichen kann, sodaß sich die Bruchgefahr verringert.

Im folgenden wird die Erfindung anhand eines in der Zeichnung dargestellten Ausführungsbeispiels näher erläutert.

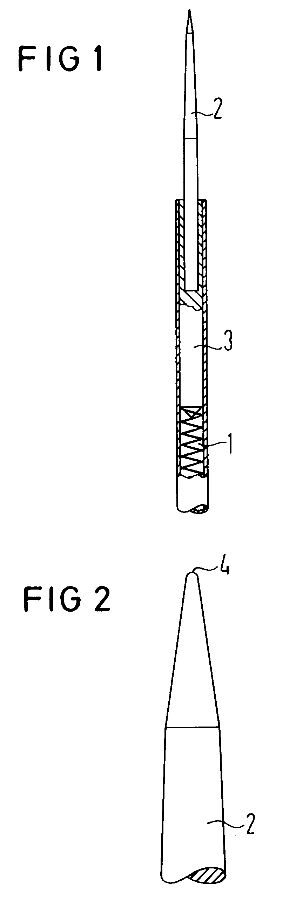

Die Figuren 1 und 2 zeigen in einer Seitenansicht und in eine vergrößerten Teilansicht einen Federkontaktstift 1 für einen Prüfadapter mit einer Tastnadel 2, die mit einem Ende in einen federnd gelagerten Kolben 3 des zylindrischen Federkontaktstifts 1 eingesetzt ist. Die Tastnadel 2 besteht vollständig aus Hartmetall und ist an ihrem freien Ende kegelförmig zugespitzt. Die Spitze weist eine kugelartige Rundung 4 mit einem Radius von ungefähr 50 Mikrometern auf. Die Tastnadel 2 ist mit ihrer Spitze auf eine Leiterplatte aufsetzbar. Die zu kontaktierenden Stellen der Leiterplatte können z. B. nach dem Bestücken mit Bauelementen durch Lötvorgänge so uneben sein, daß durch den Kontaktdruck erhebliche Seitenkräfte auftreten. Die Kontaktkraft muß so groß sein, daß Flußmittelrückstände und Oxidhäute durchdrungen werden, was entsprechend hohe Werte voraussetzt. Der entsprechend rauhe Prüfbetrieb erfordert nicht nur gute Kontakteigenschaften, sondern auch eine besondere mechanische Stabilität der Prüfspitze, die durch die Kombination des hochfesten Materiels mit besontion des hochstandfesten Materials mit der besonders sorgfältig ausgebildeten Rundung 4 der Tastnadel 2 erreicht wird.

## Patentansprüche

1. Tastnadel (2) für einen Adapter zum Prüfen von elektrischen Leiterplatten mit einer verschleißarmen Oberfläche zumindest im Bereich einer Tastspitze,
   **dadurch gekennzeichnet,**
   daß die Tastnadel (2) zumindest im Bereich der Tastspitze vollständig aus Hartmetall besteht und unmittelbar mit der Leiterplatte kontaktierbar ist, daß das freie Ende der Tastspitze eine kugelartige Rundung (4) aufweist und daß der Radius der Rundung (4) zwischen 20 und 80, vorzugsweise bei 50 Mikrometer liegt.

2. Tastnadel nach Anspruch 1,
   **dadurch gekennzeichnet,**
   daß die Tastnadel seitlich federnd auslenkbar ausgebildet und/oder gelagert ist.

FIG 1

FIG 2